# EUROPEAN PATENT APPLICATION

(11) **EP 3 372 706 A1**
(43) Date of publication of application: **12.09.2018**
(21) Application number: 16862197.7
(22) Date of filing: 04.11.2016
(51) Int. Cl.: C23C 14/06, B21D 37/01, C23C 14/24, C23C 14/32, G01N 23/20, G01N 23/207

(54) **COATING MEMBER, SURFACE COATED MOLD, AND FILM FORMATION METHOD**

(30) Priority: 05.11.2015 JP 2015217586
(71) Applicant: Fujita Giken Co., Ltd., Nomi-shi, Ishikawa 923-1101 (JP)
(72) Inventor: KITAGISHI, Yasuhiro, Nomi-shi Ishikawa 923-1101 (JP); NANJO, Yoshiyasu, Nomi-shi Ishikawa 923-1101 (JP); OKAZAKI, kenichi, Nomi-shi Ishikawa 923-1101 (JP)
(74) Representative: Goddar, Heinz J.
(86) International application number: PCT/JP2016/082803
(87) International publication number: WO 2017/078138

(57) **Abstract**

Disclosed herein is a vanadium-based coating film having a high film hardness.

When subjected to X-ray diffraction using Cu Ka radiation, the vanadium-based coating film has peaks at diffraction angles 2θ of 29.9 degrees or more but 30.3 degrees or less, 33.2 degrees or more but 33.6 degrees or less, and 69.8 degrees or more but 70.6 degrees or less, and has a maximum intensity at a diffraction angle 2θ of 33.2 degrees or more but 33.6 degrees or less. This vanadium-based coating film has a film hardness HV of 3500 to 5000, and therefore has a hardness higher than those of conventional vanadium-based coating films.

## Description

### TECHNICAL FIELD

The present invention relates to a coated member, a surface-coated mold, and a film-forming method.

### BACKGROUND ART

For example, Patent Literature 1 discloses a film-forming method in which a VN film is formed on the surface of an inorganic base material by ion plating.

### CITATION LIST

### PATENT LITERATURE

Patent Literature 1: JP 2002-371352 A

### SUMMARY OF INVENTION

### TECHNICAL PROBLEMS

It is an object of the present invention to provide a coating film having a higher film hardness.

### SOLUTIONS TO PROBLEMS

The present invention is directed to a coated member comprising: a base material; and a coating film formed on a surface of the base material, wherein the coating film is a vanadium-based coating film having a hexagonal crystal structure.

The present invention is also directed to a coated member comprising: a base material; and a coating film formed on a surface of the base material, wherein the coating film is a vanadium-based coating film that has, when subjected to X-ray diffraction using Cu Ka radiation, peaks at diffraction angles 2θ of 29.9 degrees or more but 30.3 degrees or less, 33.2 degrees or more but 33.6 degrees or less, and 69.8 degrees or more but 70.6 degrees or less, and a maximum intensity at a diffraction angle 2θ of 33.2 degrees or more but 33.6 degrees or less.

The coating film is preferably a metal compound layer represented by (VₐM₁₋ₐ)_{α}(N_{b}X_{1-b})_{β} (wherein M is a group 4a element, a 5a group element other than vanadium, a group 6a element, aluminum, silicon, or a composite of two or more of them, X is carbon, oxygen, boron, or a composite of two or more of them, a and b are each 0.8 or more but 1 or less, and a value of b/a is larger than that of a vanadium-based coating film having a NaCl-type crystal structure).

The coated member preferably further comprises a vanadium-based coating film having a NaCl-type crystal structure in addition to the coating film, wherein these coating films are mixed.

The present invention is also directed to a coated member comprising: a base material; and a coating film formed on a surface of the base material, wherein the coating film is a vanadium-based coating film formed by an arc ion plating apparatus using vanadium metal as a main evaporation source on a surface orthogonal to a surface of the base material opposed to the evaporation source at a film-forming temperature of 100°C or more but 450°C or less, a bias voltage applied to the base material of 80 V or more but 300 V or less, and a nitrogen gas pressure of 2.0 Pa or more but 8.0 Pa or less in such a manner that a relative position of the base material and the evaporation source is fixed so that a distance from the evaporation source to the opposed surface of the base material is 180 mm or more but 230 mm or less.

The present invention is also directed to a surface-coated mold comprising: a mold main body; and a coating film that coats at least part of a surface of the mold main body, wherein the coating film is a vanadium-based coating film having a hexagonal crystal structure.

The present invention is also directed to a surface-coated mold comprising: a mold main body; and a coating film that coats at least part of a surface of the mold main body, wherein the coating film is a vanadium-based coating film that has, when subjected to X-ray diffraction using Cu Ka radiation, peaks at diffraction angles 2θ of 29.9 degrees or more but 30.3 degrees or less, 33.2 degrees or more but 33.6 degrees or less, and 69.8 degrees or more but 70.6 degrees or less, and a maximum intensity at a diffraction angle 2θ of 33.2 degrees or more but 33.6 degrees or less.

It is to be noted that the term "peak" used herein refers to a point where a maximum intensity is locally obtained.

### ADVANTAGEOUS EFFECTS OF INVENTION

According to the present invention, it is possible to provide a coating film having a higher film hardness.

### BRIEF DESCRIPTION OF DRAWINGS

FIG. 1 is a schematic diagram for explaining the formation of a coating film by an AIP apparatus 5.
FIG. 2 is a diagram for explaining the surface of a base material 10 on which a novel VN film 20 is to be formed.
FIG. 3 is a graph showing the X-ray diffraction data of an opposed surface in Example 1.
FIG. 4 is a graph showing the X-ray diffraction data of an orthogonal surface in Example 1.
FIG. 5 is a graph showing the X-ray diffraction data of an opposed surface in Example 2.
FIG. 6 is a graph showing the X-ray diffraction data of an orthogonal surface in Example 2.
FIG. 7 is a graph showing the distribution of film hardnesses of Examples.
FIG. 8 is a TEM image of a conventional VN film 22.
FIG. 9 is an electron diffraction pattern of the conventional VN film 22.
FIG. 10 is a TEM image of a novel VN film 20.
FIG. 11 is an electron diffraction pattern of the novel VN film 20.

### DESCRIPTION OF EMBODIMENTS

First, the background of the present invention will be described.

Various coating films have been developed to impart abrasion resistance to molds, cutting tools, and jigs and tools. In particular, high hardness films have high abrasion resistance, and therefore high hardness films having a Vickers hardness (hereinafter, referred to as "HV") of about 3500 are used such as TiCN films, TiC films, VC films, TiAlN films, and Si-containing films. In general, VN films have a NaCl-type crystal structure and a hardness HV of 2000 to 3000 lower than those of the above-mentioned high hardness films, and are therefore not often used singly as abrasion-resistant coating films.

It is to be noted that the hardness HV refers to a hardness measured in accordance with JIS Z 2244.

In light of the above circumstances, it is an object of the present invention to provide a novel VN film that has a high hardness to impart high abrasion resistance to molds, cutting tools, jigs and tools, etc.

The novel VN film has a film hardness HV of 3000 to 5000, and is formed on the surface of a mold or cutting tool by ion plating.

Unlike VN films having a NaCl-type crystal structure, the novel VN film is a vanadium-based coating film that has, when subjected to X-ray diffraction using Cu Ka radiation, peaks at diffraction angles 2θ of 29.9 degrees or more but 30.3 degrees or less, 33.2 degrees or more but 33.6 degrees or less, and 69.8 degrees or more but 70.6 degrees or less, and a maximum intensity at a diffraction angle 2θ of 33.2 degrees or more but 33.6 degrees or less. That is, the novel VN film according to the present application has a crystal structure different from that of conventional VN films (which have peaks at diffraction angles 2θ of about 38 degrees, about 44 degrees, and about 64 degrees), and has a hardness higher than those of conventional VN films (HV 2000 to HV 3000).

It is to be noted that another metal element (M) other than vanadium V may be added to the novel VN film to obtain a film having the above-described hardness. The content of V is 80% or more of the total of all the metal elements used. Such a coating film is sometimes called a novel VMN film. In the present application, the vanadium-based coating film refers to a coating film containing vanadium as a main metal, and includes a VN film and a VMN film.

Hereinbelow, an embodiment of the present invention will be described with reference to the drawings. A novel VN film 20 (which will be described later) is formed by physical vapor deposition (PVD). More specifically, the physical vapor deposition is ion plating.

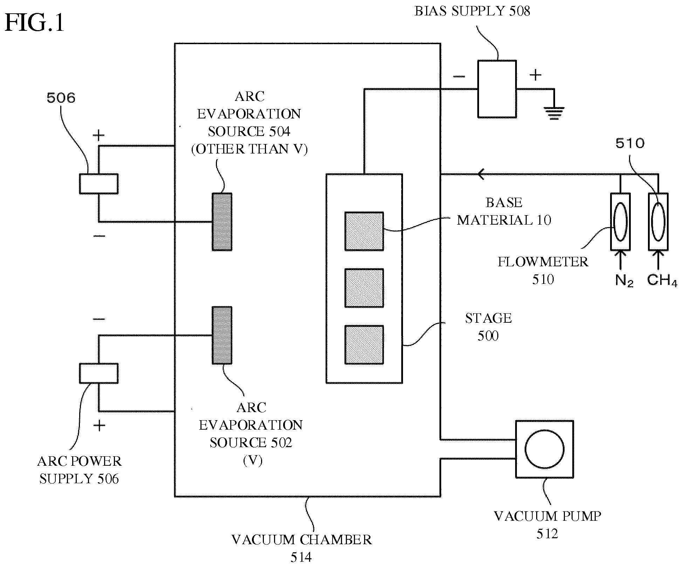

FIG. 1 is a schematic diagram for explaining the formation of a coating film by an AIP apparatus 5.

As illustrated in FIG. 1, the AIP apparatus 5 includes a stage 500 on which a base material 10 is to be placed, an arc evaporation source 502 of vanadium, an arc evaporation source 504 of a metal other than vanadium, arc power supplies 506 that apply a voltage to the arc evaporation sources, a bias supply 508 that applies a voltage to the stage 500, flow meters 510 for measuring and adjusting the partial pressure of a gas (e.g., nitrogen gas), a vacuum pump 512, and a vacuum chamber 514.

The AIP apparatus 5 has such a structure as described above to form a coating film by ion plating using arc discharge in vacuum.

In particular, in this embodiment, a coating film is formed in such a manner that the relative position and direction of the stage 500 (i.e., the base material 10) and the arc evaporation source 502 are fixed.

It is to be noted that this embodiment will be specifically described with reference to a case where the arc evaporation source 502 of vanadium and the arc evaporation source 504 of a metal other than vanadium are used in combination to form a novel VN film of an alloy mainly containing vanadium.

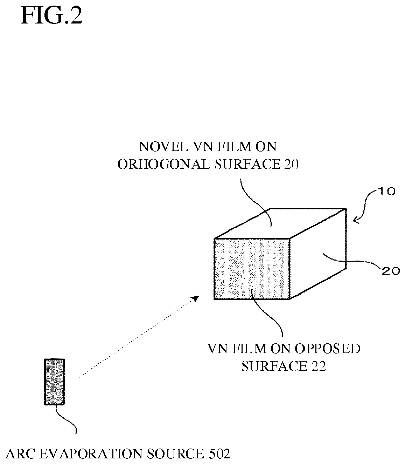

FIG. 2 is a diagram for explaining the surface of the base material 10 on which the novel VN film 20 is to be formed.

As illustrated in FIG. 2, a conventional VN film 22 is formed on a surface of the base material 10 opposed to the arc evaporation source 502, and a novel VN film 20 is formed on a surface orthogonal to the opposed surface.

Therefore, a mold or a cutting tool (base material 10) is placed on the stage 500 in such a manner that the surface of the mold or cutting tool (base material 10) particularly required to have abrasion resistance is orthogonal to the opposed surface facing the arc evaporation source 502.

It is to be noted that the film-forming method used in this embodiment is very sensitive to a film-forming atmosphere, and the conventional VN film 22 having a NaCl-type crystal structure and the novel VN film 20 are mixed. More specifically, the conventional VN film 22 is mainly formed on the opposed surface of the base material 10, and the novel VN film 20 is mainly formed on the orthogonal surface of the base material 10, but the ratio between the conventional VN film 22 and the novel VN film 20 is changed depending on conditions. Further, the novel VN film 20 mixed with the conventional VN film 22 tends to be whiter than the conventional VN film 22. Therefore, the novel VN film 20 can also be defined as a coating film in a relatively white region of a vanadium-based coating film formed on the base material 10 under conditions according to the present application.

Further, the coating film often has an internal structure made of not a single film but a multi-layer film composed of the conventional VN film 22 having a NaCl-type crystal structure and the novel VN film 20. The novel VN film 20 is often laminated on the conventional VN film 22 directly formed on the base material 10.

When a coating film is formed by the AIP apparatus 5, a film-forming temperature is preferably 700°C or less, and a bias voltage applied to the base material 10 (the voltage of the bias supply 508) is preferably 20 V to 400 V. Further, the gas pressure of nitrogen in the vacuum chamber 514 during film formation is preferably 1 Pa to 20 Pa.

The film-forming temperature is more preferably 100°C or more but 450°C or less, the bias voltage applied to the base material 10 is more preferably 80 V or more but 300 V or less, the gas pressure of nitrogen is more preferably 2.0 Pa or more but 8.0 Pa or less. A coating film is formed on the orthogonal surface of the base material 10 by the AIP apparatus 5 using only vanadium metal as an arc evaporation source in such a manner that the relative position of the arc evaporation source 502 and the base material 10 is fixed so that the distance from the arc evaporation source 502 to the opposed surface of the base material 10 is 180 mm or more but 230 mm or less.

### (Example 1)

The base material 10 was placed on the stage 500 of the AIP apparatus 5 and heated to 400°C under vacuum. Then, an electric current of 80A was supplied from the arc power supply 506 to the arc evaporation source 502 of vanadium metal to evaporate and ionize vanadium to perform ion bombardment for 2 minutes at a voltage of the base material 10 of -800 V. Then, nitrogen gas was introduced into the vacuum chamber 514, and the pressure of the nitrogen gas was adjusted to 3 Pa. Then, a film was formed for 50 minutes while the film-forming temperature was reduced to 250°C and the bias voltage was reduced to -80 V.

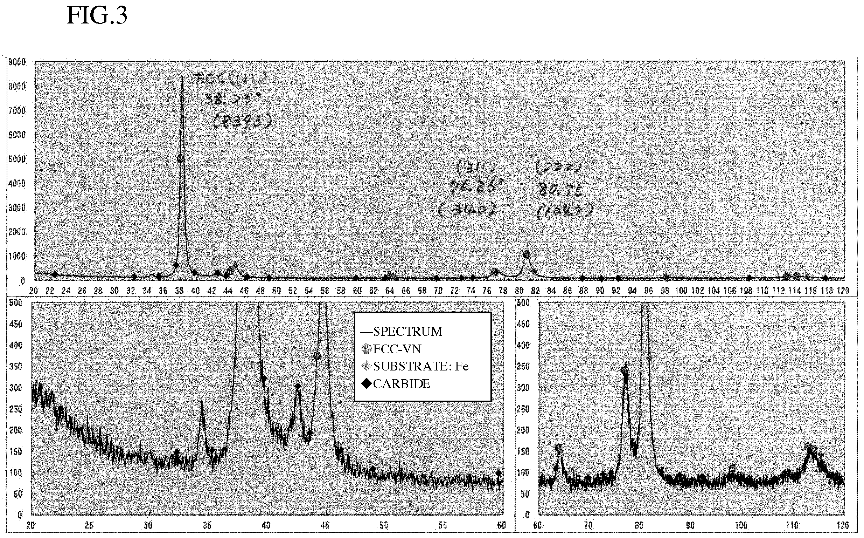

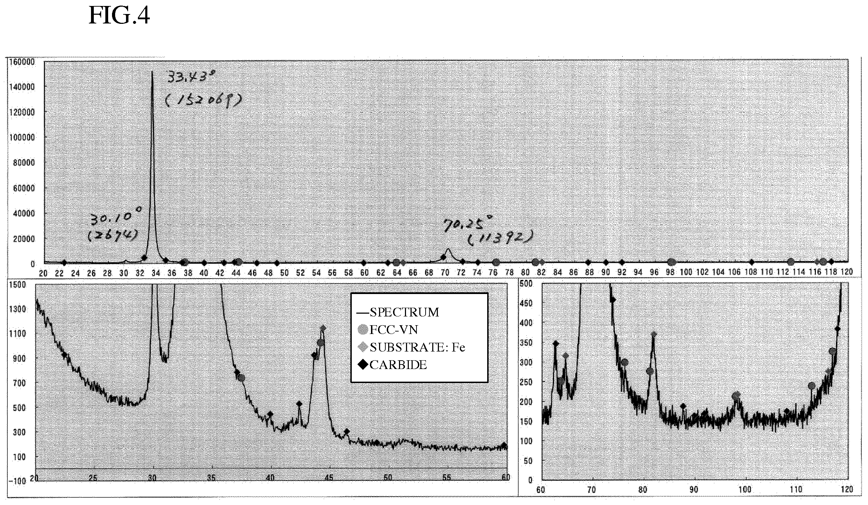

The film formed on the opposed surface of the base material 10 had a film hardness HV of 2700, and the film formed on the orthogonal surface of the base material 10 had a film hardness HV of 4000. The X-ray diffraction data (diffraction angle 2θ) of this opposed surface is shown in FIG. 3, and the X-ray diffraction data (diffraction angle 2θ) of this orthogonal surface is shown in FIG. 4. In FIG. 4, a strong peak is observed at 33.4 degrees, which is unique to the novel VN film 20.

### (Example 2)

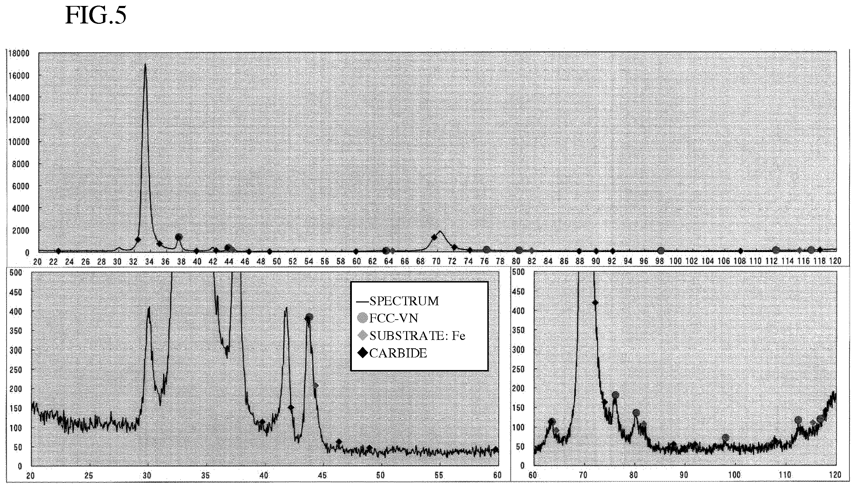

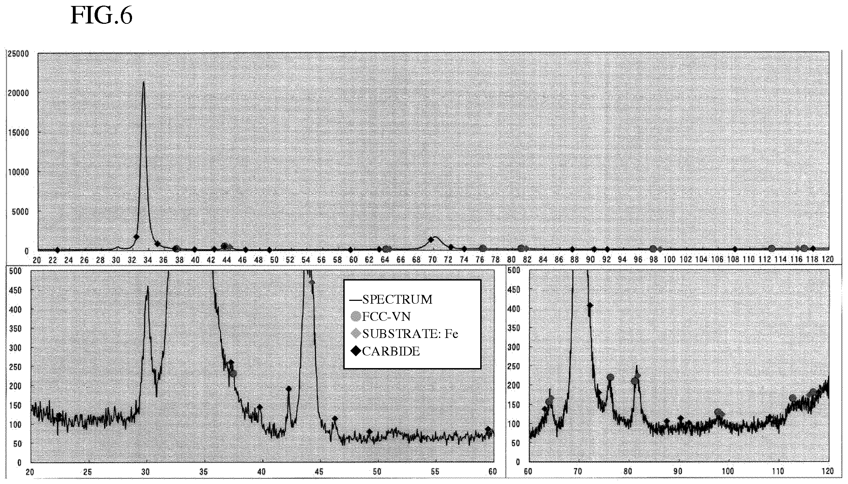

The base material 10 was set and ion bombardment was performed in the same manner as in Example 1. Then, a VN film was formed under conditions of a nitrogen gas pressure of 5 Pa, a film-forming temperature of 300°C, a bias voltage of -80 V, and a film-forming time of 40 minutes. The VN film formed on the opposed surface of the base material 10 had a film hardness HV of 3800, and the VN film formed on the orthogonal surface of the base material 10 had a film hardness HV of 4150. The X-ray diffraction data (diffraction angle 2θ) of this opposed surface is shown in FIG. 5, and the X-ray diffraction data (diffraction angle 2θ) of this orthogonal surface is shown in FIG. 6. As can be seen from FIG. 5 and FIG. 6, both the opposed surface and the orthogonal surface showed a strong peak at 33.4 degrees unique to the novel VN film 20.

### (Example 3)

The base material 10 was set and ion bombardment was performed in the same manner as in Example 1. Then, a VN film was formed under conditions of a nitrogen gas pressure of 7 Pa, a film-forming temperature of 200°C, a bias voltage of -300 V, and a film-forming time of 40 minutes. The film formed on the opposed surface of the base material 10 had a film hardness HV of 2000, and the film formed on the orthogonal surface of the base material 10 had a film hardness HV of 4500. The film formed on the orthogonal surface is the novel VN film 20.

### (Example 4)

An evaporation source of vanadium metal was provided as the arc evaporation source 502 of the AIP apparatus 5, and an evaporation source of chromium metal was provided as the adjacent arc evaporation source 504. Then, as shown in FIG. 1, a plurality of the base materials 10 were set and ion bombardment was performed in the same manner as in Example 1. Then, a VCrN film was formed under conditions of a nitrogen gas pressure of 7 Pa, a film-forming temperature of 250°C, a bias voltage of -140V, and a film-forming time of 40 minutes by supplying an arc current of 80A to the evaporation source of vanadium metal and the evaporation source of chromium metal to evaporate and ionize metals. The chromium content of the VCrN film was higher when the base material 10 was farther from the evaporation source of vanadium metal and closer to the evaporation source of chromium metal (i.e., the coating film formed on the uppermost base material 10 in FIG. 1 had the maximum chromium content). The coating films whose ratios of chromium to vanadium were 10% and 20% had a film hardness HV of 3000, and the coating film whose ratio of chromium to vanadium was 30% had a film hardness HV of 2300. In the X-ray diffraction data (diffraction angle 2θ) of the coating films whose ratios of chromium to vanadium were 10% and 20%, a strong peak at 33.4°C unique to the novel VN film 20 was observed. Therefore, these coating films are considered to be novel VMN films.

### (Film hardnesses HV of Examples)

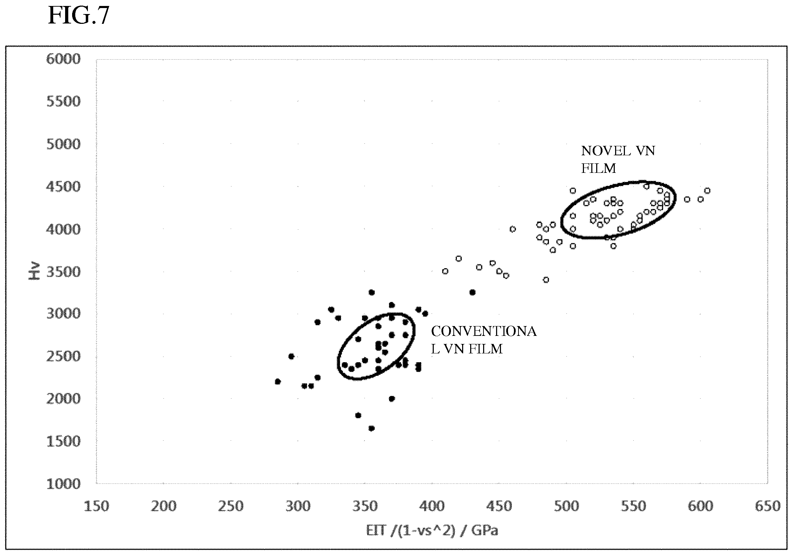

FIG. 7 is a graph showing the distribution of film hardnesses of the films. In FIG. 7, "hard VN" corresponds to each of the novel VN films 20 obtained in Examples according to the present application, and "normal VN" corresponds to the conventional VN film 22. As can be seen also from FIG. 7, it can be said that the novel VN film 20 is a vanadium-based coating film having a remarkably improved film hardness.

### (Comparison of crystal structures)

Hereinbelow, the comparison of crystal structures was made between the novel VN film 20 and the conventional VN film 22.

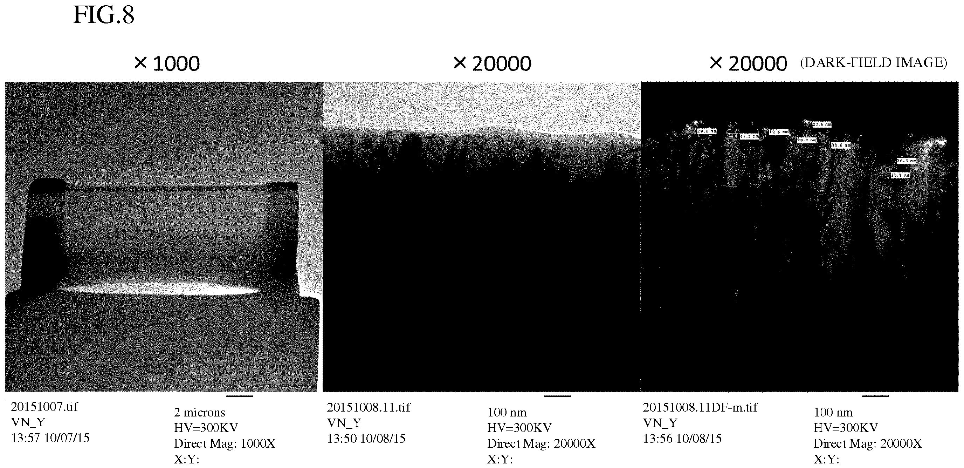

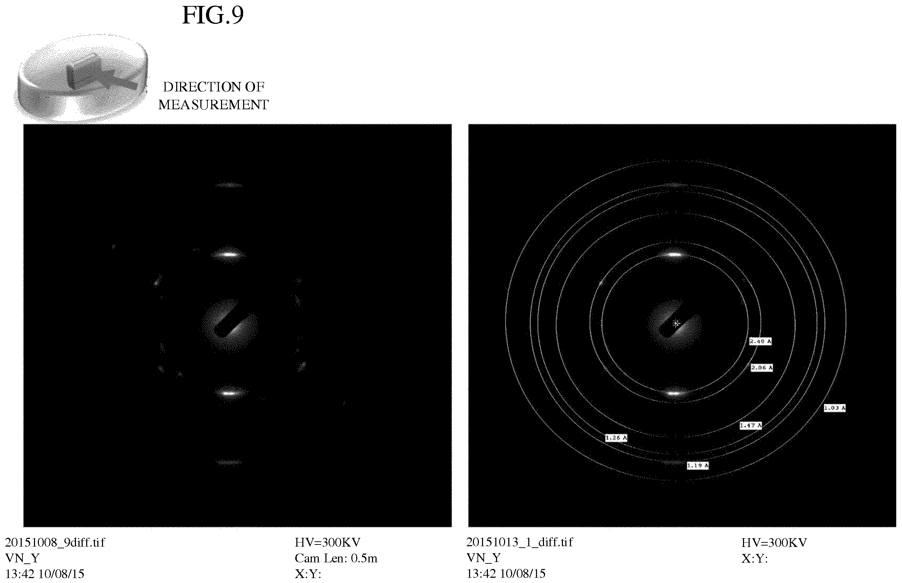

FIG. 8 is a TEM image of the conventional VN film 22, and FIG. 9 is an electron diffraction pattern of the conventional VN film 22.

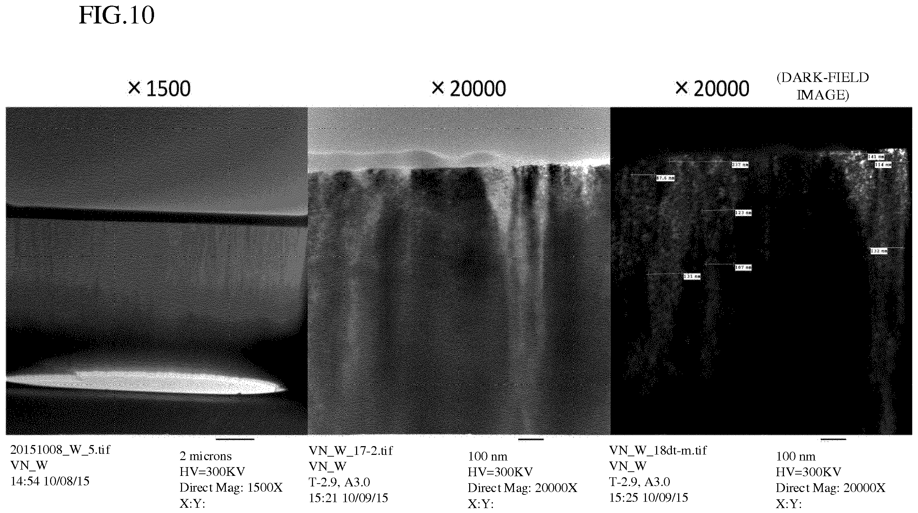

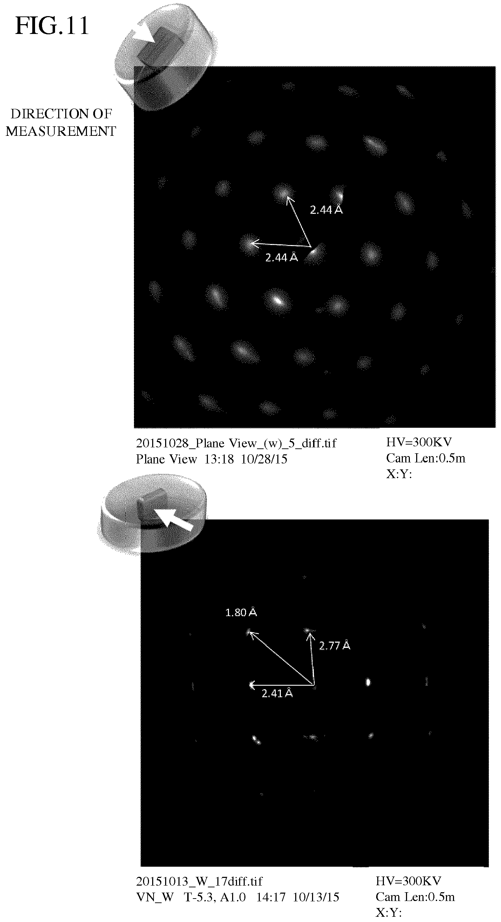

FIG. 10 is a TEM image of the novel VN film 20, and FIG. 11 is an electron diffraction pattern of the novel VN film 20.

As shown in FIG. 8, crystal grains having a width of about 20 to 100 nm were present in the conventional VN film 22. As shown in FIG. 9, a Debye ring was obtained in the electron diffraction pattern of the conventional VN film 22. Therefore, the conventional VN film 22 is in a state close to a polycrystalline state. The crystal structure of the conventional VN film 22 is a face-centered structure (FCC).

On the other hand, as shown in FIG. 10, crystal grains having a width of about 100 to 300 nm were present in the novel VN film 20. That is, the novel VN film 20 is in a state where crystal grains larger than those present in the conventional VN film 22 are distributed.

Further, as shown in FIG. 11, a Debye ring is not observed in the electron diffraction pattern of the novel VN film 20, which reveals that the novel VN film 20 is in a crystalline state where the crystal grains are oriented in a certain direction. The novel VN film 20 was found to have a hexagonal crystal structure. The novel VN film 20 is considered to have a symmetric crystal structure having a 6-fold rotoinversion axis.

As described above, the crystal constituting the novel VN film 20 is obviously different from the crystal constituting the conventional VN film 22 in crystal gran size and crystal structure.

### (Preferred uses)

Hereinbelow, preferred uses of the novel VN film 20 will be exemplified.

The novel VN film 20 has a high hardness, and therefore can be used as, for example, the surface of a mold for use in plastic forming of a high-tensile steel plate. Examples of the plastic forming include bending, spinning, and burring.

As described above, the novel VN film 20 according to this embodiment has a higher film hardness than the conventional VN film. Therefore, a mold or cutting tool coated with this novel VN film 20 has high abrasion resistance.

### REFERENCE SIGNS LIST

5 AIP apparatus
10 Base material
20 Novel VN film
500 Stage
502, 504 Arc evaporation sources

## Claims

1. A coated member comprising:
a base material; and
a coating film formed on a surface of the base material,
wherein
the coating film is a vanadium-based coating film having a hexagonal crystal structure.

2. A coated member comprising:
a base material; and
a coating film formed on a surface of the base material,
wherein
the coating film is a vanadium-based coating film that has, when subjected to X-ray diffraction using Cu Ka radiation, peaks at diffraction angles 2θ of 29.9 degrees or more but 30.3 degrees or less, 33.2 degrees or more but 33.6 degrees or less, and 69.8 degrees or more but 70.6 degrees or less, and a maximum intensity at a diffraction angle 2θ of 33.2 degrees or more but 33.6 degrees or less.

3. The coated member according to claim 2, wherein the coating film is a metal compound layer represented by (VₐM1-a)_{α}(N_{b}X_{1-b})_{β} (wherein M is a group 4a element, a 5a group element other than vanadium, a group 6a element, aluminum, silicon, or a composite of two or more of them, X is carbon, oxygen, boron, or a composite of two or more of them, a and b are each 0.8 or more but 1 or less, and a value of b/a is larger than that of a vanadium-based coating film having a NaCl-type crystal structure).

4. The coated member according to claim 3, further comprising a vanadium-based coating film having a NaCl-type crystal structure in addition to the coating film,
wherein
these coating films are mixed.

5. A coated member comprising:
a base material; and
a coating film formed on a surface of the base material,
wherein
the coating film is a vanadium-based coating film formed by an arc ion plating apparatus using a vanadium metal as a main evaporation source on a surface orthogonal to a surface of the base material opposed to the evaporation source at a film-forming temperature of 100°C or more but 450°C or less, a bias voltage applied to the base material of 80 V or more but 300 V or less, and a nitrogen gas pressure of 2.0 Pa or more but 8.0 Pa or less in such a manner that a relative position of the base material and the evaporation source is fixed so that a distance from the evaporation source to the opposed surface of the base material is 180 mm or more but 230 mm or less.

6. A surface-coated mold comprising:
a mold main body; and
a coating film that coats at least part of a surface of the mold main body,
wherein
the coating film is a vanadium-based coating film having a hexagonal crystal structure.

7. A surface-coated mold comprising:
a mold main body; and
a coating film that coats at least part of a surface of the mold main body,
wherein
the coating film is a vanadium-based coating film that has, when subjected to X-ray diffraction using Cu Ka radiation, peaks at diffraction angles 2θ of 29.9 degrees or more but 30.3 degrees or less, 33.2 degrees or more but 33.6 degrees or less, and 69.8 degrees or more but 70.6 degrees or less, and a maximum intensity at a diffraction angle 2θ of 33.2 degrees or more but 33.6 degrees or less.
